Europäisches Patentamt

European Patent Office

Office européen des brevets

(11) Numéro de publication: **0 267 825**
**A1**

(12) **DEMANDE DE BREVET EUROPEEN**

(21) Numéro de dépôt: 87402276.7

(22) Date de dépôt: 13.10.87

(51) Int. Cl.⁴: **G 02 F 1/133**
**H 01 L 29/78**

(30) Priorité: 17.10.86 FR 8614411

(43) Date de publication de la demande:
**18.05.88 Bulletin 88/20**

(84) Etats contractants désignés: **BE CH DE FR LI**

(71) Demandeur: **THOMSON GRAND PUBLIC**
**74, rue du Surmelin**
**F-75020 Paris (FR)**

(72) Inventeur: **Chartier, Eric**
**THOMSON-CSF SCPI 19, avenue de Messine**
**F-75008 Paris (FR)**

(74) Mandataire: **Lepercque, Jean et al**
**THOMSON-CSF SCPI 19, avenue de Messine**
**F-75008 Paris (FR)**

(54) Ecran de visualisation électrooptique à transistors de commande et procédé de réalisation.

(57) L'invention concerne un écran de visualisation électrooptique et notamment une structure de transistor de commande
réalisé en couches minces. Ce transistor comporte notamment
un plot (4) en matériau isolant situé entre le drain (DR) et la
source (SO) du transistor et recouvrant une zone (D) située au
dessus de la grille (GR). Ce plot protège de la lumière la zone
active du transistor.

L'invention concerne également un procédé de réalisation
d'un tel écran.

L'invention est particulièrement applicable aux écrans à
cristaux liquide.

FIG_13

**Description**

ECRAN DE VISUALISATION ELECTROOPTIQUE A TRANSISTORS DE COMMANDE ET PROCEDE DE
REALISATION

L'invention concerne un écran de visualisation électrooptique à transistors de commande et plus particulièrement un écran plat dans lequel la commande de chaque élément d'image à visualiser se fait à l'aide d'un transistor de commande. Elle est applicable à la réalisation d'écrans plats à cristal liquide de grande surface dont les points de commande se font par intégration sous forme de couches minces. Le procédé selon l'invention permet une réalisation d'un écran par un procédé redondant et un nombre minimal de masques de lithographie.

Comme il est connu, ces écrans comportent généralement un grand nombre de points élémentaires ou éléments d'image de forme carrée ou rectangulaire. Ces éléments d'image doivent être adressés individuellement. La définition de l'écran est fonction du nombre de points susceptibles de recevoir une information. La commande de chaque point se fait par application d'un champ électrique à travers le cristal liquide. Pour la visualisation d'informations alphanumériques ou graphiques, il a été proposé des affichages de type matriciel. Chaque élément d'image est alors défini par l'intersection de deux réseaux de conducteurs orthogonaux appelés lignes et colonnes.

L'adressage de ces écrans matriciels de visualisation revêt une importance de plus en plus considérable au fur et à mesure qu'on cherche à en augmenter la définition, c'est-à-dire le nombre de points élémentaires d'image.

Les points élémentaires étant adressés séquentiellement ligne par ligne, le nombre de lignes pouvant être adressées est en général limité par les caractéristiques de l'effet électrooptique du cristal liquide utilisé. La possibilité d'adresser un grand nombre de lignes (>100) se fait alors au détriment des autres caractéristiques de l'écran (diminution du contraste et de l'angle de vue).

Pour améliorer les performances de ces écrans, on peut mettre en série avec chaque point image (constituant une capacité) un transistor ou un élément non linéaire. L'ensemble se comporte alors comme un élément mémoire.

Actuellement, les exigences de la technique en matière d'écran de visualisation portent sur une meilleure définition de l'image. Dans le cas des écrans du type à affichage matriciel, on est alors amené à concevoir des dispositifs comportant un nombre élevé de lignes ou de colonnes d'adressage. Leur nombre peut aller jusqu'à 1024 voire au-delà. Ceci augmente d'autant le nombre de transistors de commande. Pour la fabrication en série, il est nécessaire notamment d'obtenir un rendement élevé, une bonne reproductibilité et une grande stabilité de ces composants. Il est en outre nécessaire d'adapter, et ce également avec une bonne reproductibilité, les caractéristiques électriques du composant à celle de la cellule associée.

Une manière maintenant usuelle de résoudre ce problème et d'améliorer les performances de ces écrans consiste à réaliser cet adressage à l'aide d'une matrice de transistors en couches minces : ceci revient à coupler directement l'effet électrooptique sur un "circuit intégré", géant mais de basse résolution, chargé d'assurer les fonctions d'aiguillage et de mémorisation de l'information.

Cette approche présente des difficultés technologiques certaines, dans la réalisation tant des transistors en couches minces que des niveaux conducteurs d'interconnexion; en particulier, il est impératif que, parmi les très nombreux croisements entre les lignes et les colonnes du réseau d'interconnexion, aucun ne soit défectueux.

En effet, selon une technique usuelle, les transistors sont situés aux points de croisement de conducteurs de lignes et de conducteurs de colonnes isolés entre eux, de telle façon qu'une différence de potentiel appropriée appliquée entre une ligne et une colonne détermine la conduction du transistor connecté entre cette ligne et cette colonne.

Pour fabriquer cet écran, il est souhaitable d'avoir un nombre minimal de pas de photolithographie et il est impératif que l'ensemble du dispositif soit insensible à la lumière (d'où la nécessité d'un écran lumière). De plus, pour avoir un maximum de teintes de gris, il est nécessaire de minimiser les capacités parasites de couplage en particulier celles dues au transistor.

L'invention concerne un écran et un procédé de fabrication d'un écran dont les transistors sont fabriqués pour obtenir ces résultats en un nombre minimum de masquage, soit cinq et, où les dimensions les plus critiques (recouvrement grille, source drain, des masques de photolithographie de lumière) ne dépendent pas de la précision de superposition des masques. Ces transistors utilisent des techniques d'autoalignement pour minimiser les capacités parasites.

L'invention concerne donc un écran de visualisation électrooptique à transistors de commande comportant :

- une première et une deuxième lames parallèles enserrant un matériau électrooptique ;
- la première lame étant munie sur sa face en contact avec le matériau électrooptique d'une matrice d'éléments image arrangés en lignes et colonnes, d'électrodes de commande de ligne à raison d'un électrode associée à chaque ligne d'éléments image de ladite matrice et disposée parallèlement à chaque ligne d'élements image, et de transistors de commande à raison d'un transistor par élément image couplant celui-ci à ladite électrode de commande de ligne ;
- la deuxième lame étant munie sur sa face en contact avec le matériau électrooptique d'au moins une électrode ;
caractérisé en ce que chaque transistor comporte :
- une grille connectée à une électrode de commande de ligne et recouverte d'une couche d'isolant ainsi que d'une couche de matériau semiconducteur amorphe ;

- un drain connecté à une électrode de commande de colonne, reposant sur la couche de matériau semiconducteur amorphe par l'intermédiaire d'une couche de semiconducteur dopé, ce drain ne recouvrant pas la zone située au-dessus de la grille ;
- un élément métallique constituant la source du transistor, connecté à un élément image et reposant sur la couche de matériau semiconducteur amorphe par l'intermédiaire d'une couche de semiconducteur dopé, cette source ne recouvrant pas la zone située audessus de la grille ;
- un plot en matériau isolant situé entre le drain et la source, recouvrant la zone située au-dessus de la grille et ne laissant pas passer la lumière.

L'invention concerne également un procédé de réalisation d'un écran de visualisation caractérisé en ce qu'il comporte les étapes suivantes :

a) une première étape de dépôt sur une face d'un substrat d'une première couche de métal ;

b) une deuxième étape de découpe par gravure dans cette couche de métal, d'électrodes de lignes et de grilles connectées à ces électrodes de lignes ;

c) une troisième étape de dépôt d'une première couche d'un matériau isolant ;

d) une quatrième étape de dépôt d'une couche d'un matériau semiconducteur amorphe ;

e) une cinquième étape de découpe par gravure, dans la couche de matériau semiconducteur amorphe, de mésas ;

f) une sixième étape de dépôt, sur l'ensemble ainsi obtenu, d'une deuxième couche épaisse d'un matériau isolant ;

g) une septième étape d'élimination de la deuxième couche de matériau isolant de façon à obtenir des plots en matériau isolant situés au-dessus des grilles ;

h) une huitième étape de dépôt d'une couche fortement dopée de matériau semiconducteur ;

i) une neuvième étape de dépôt d'une deuxième couche de métal ;

j) une deuxième étape de gravure, sur chaque mésa, d'un drain atteignant un plot situé sur la mésa ainsi qu'une source atteignant ledit plot et se prolongeant vers l'emplacement d'un élément image ;

k) une onzième étape de dépôt d'une troisième couche de métal ;

l) une douzième étape de gravure, dans la troisième couche de métal, d'électrodes de colonnes en contact avec des drains ;

m) une treizième étape de dépôt d'une couche conductrice ;

n) une quatorzième étape de gravure, dans ladite couche conductrice, d'éléments images en contact avec des sources ;

o) une quinzième étape de finition d'un écran comportant les opérations suivantes :
- dépôt d'une couche d'ancrage ;
- mise en place de cales d'épaisseur ;
- réalisation d'une contre lame avec contre électrode transparente recouverte d'une couche d'ancrage ;
- mise en place d'un cristal liquide.

Les différents objets et caractéristiques de l'invention apparaîtront plus clairement dans la description qui va suivre faite en se reportant aux figures annexées qui représentent :

- la figure 1, une vue en perspective d'un exemple de réalisation d'un écran à cristal liquide selon l'art connu ;

- la figure 2, une vue générale d'un exemple de réalisation de l'écran à cristal liquide selon l'invention ;

- les figures 3 à 14, différentes étapes du procédé de réalisation de l'écran à cristal liquide selon l'invention ;

- les figures 15 à 24, différentes étapes d'une variante du procédé de réalisation de l'écran à cristal liquide selon l'invention.

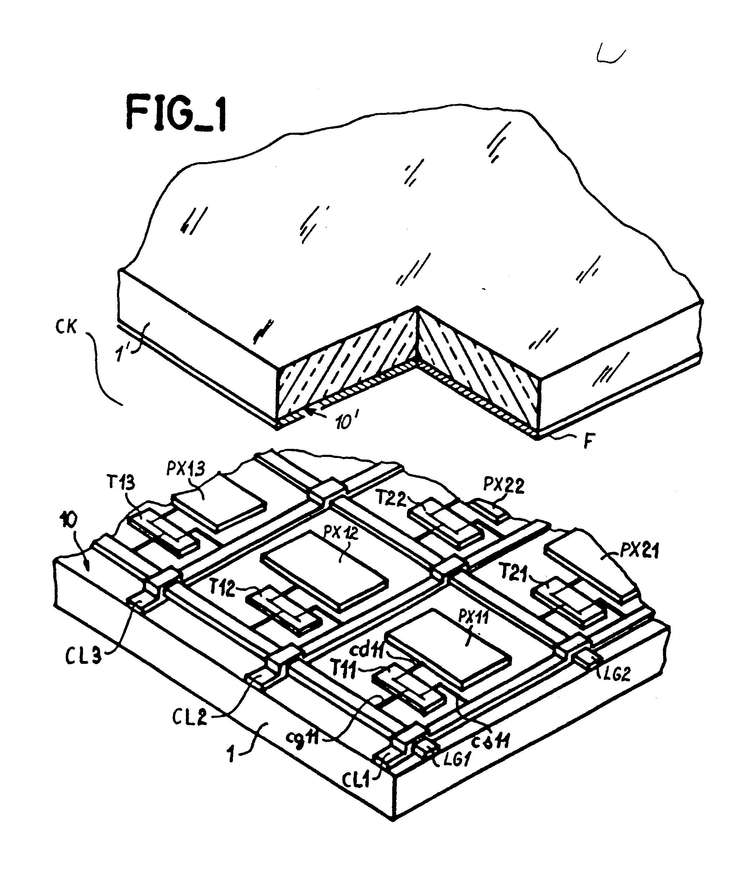

En se reportant à la figure 1, on va tout d'abord décrire un exemple d'écran à cristal liquide connu dans la technique tel que décrit par exemple dans les demandes de brevets français N° 85.12804 ou 85.16935.

Sur cette figure on trouve sur une face 10 d'une première lame 1 les conducteurs de lignes LG1 et LG2, les conducteurs de colonnes CL1, CL2 et CL3. Connectés sensiblement à chaque point de croisement, on trouve également des transistors et des éléments images tels que le transistor T11 et l'élément image PX11 situés au croisement du conducteur de ligne LG1 et du conducteur de colonne CL1.

Une deuxième lame 1', de préférence en verre, est munie d'au moins une électrode F et détermine avec une de ces faces 10' et la face 10 de la lame 1, un espace dans lequel est placé un cristal liquide CX.

La lame 1' est transparente. Un élément image de la face 10 telle que PX11, la lame 1' en vis-à-vis et le cristal liquide qui les séparent constituent une cellule à cristal liquide de l'écran.

Le fonctionnement d'un tel écran est connu. Rappelons simplement que pour afficher une information sur une cellule de cristal liquide, il faut appliquer à une ligne (LG1 par exemple) et une colonne (CL1 par exemple) des potentiels appropriés rendant conducteur le transistor T11 qui applique alors un potentiel à l'élément image PX11 de telle façon que l'élément d'image PX11 de la cellule CL11 soit soumise à une différence de potentiel permettant un changement d'état du cristal liquide.

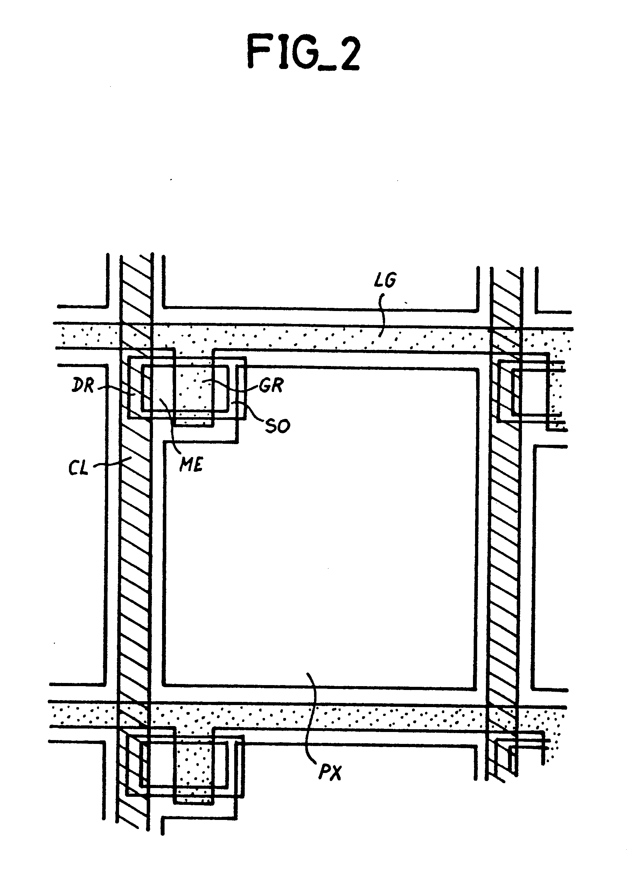

En se reportant aux figures 2, 13 et 14 on va maintenant décrire un exemple de réalisation d'un écran à cristal liquide selon l'invention.

La figure 2 représente une vue générale mettant en évidence l'organisation de l'écran à cristal liquide selon l'invention. On trouve sur cette figure des éléments image, tel que PX, arrangés en matrice et commandés par des électrodes de lignes et de colonnes telles que LG et CL.

A chaque point de croisement d'une électrode de ligne et d'une électrode de colonne est prévu un transistor de commande. Ce transistor de commande comporte une grille GR réalisée sous la forme d'une identation solidaire d'une électrode de la ligne LG.

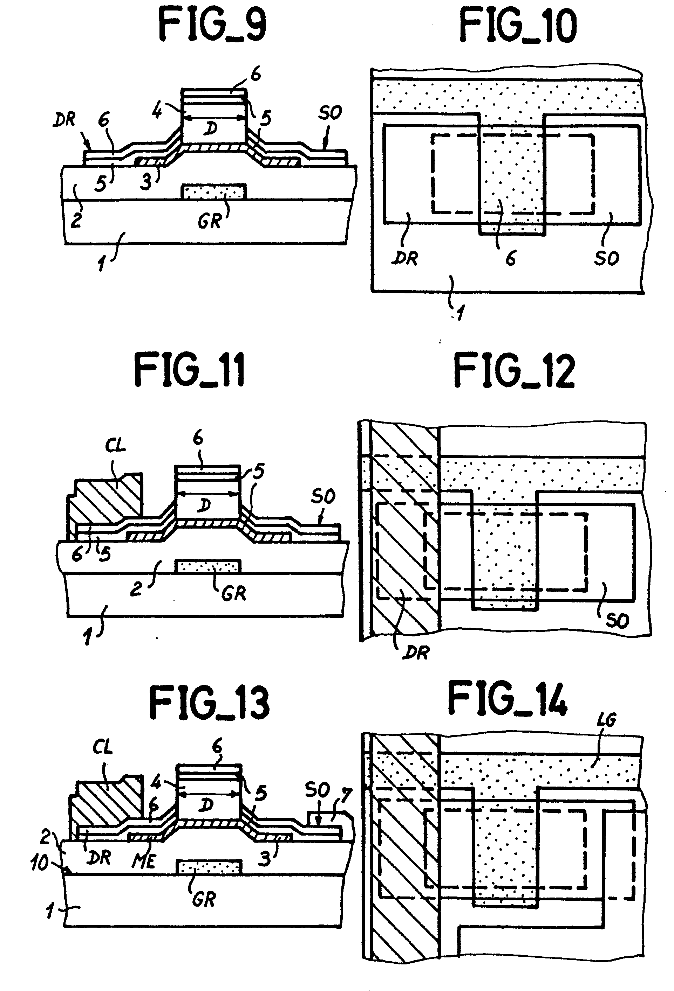

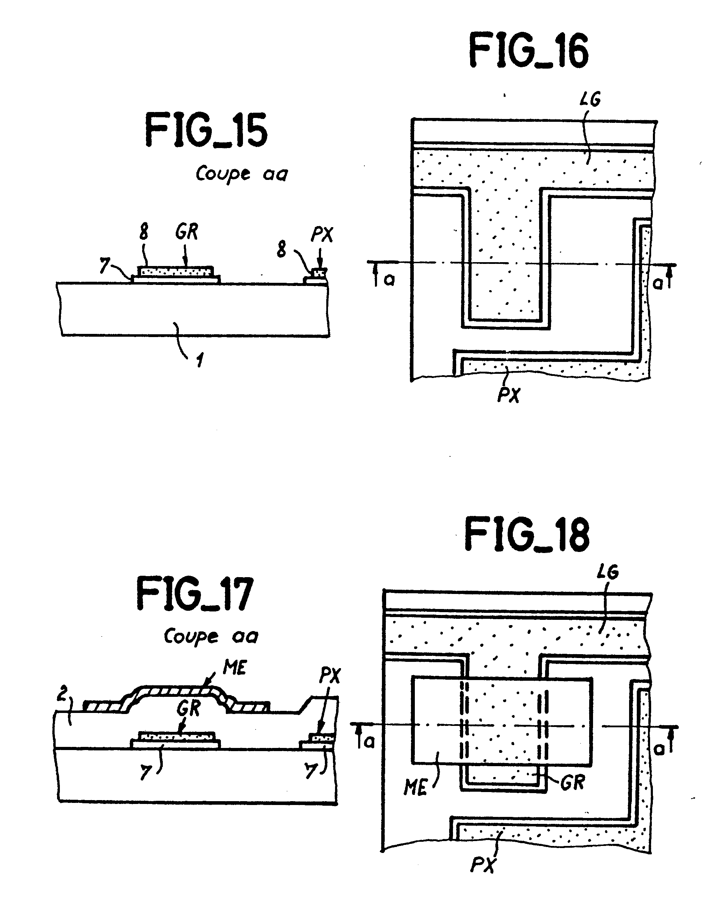

Comme cela est visible sur la figure 13, la grille GR de même que l'électrode de ligne LG sont réalisées sur une face 10 d'un substrat. La grille GR et l'électrode LG peuvent être constituées d'une couche d'oxyde d'indium recouverte d'une couche métallique, comme cela est représenté en figures 15 et 16 avec la couche d'oxyde d'indium légèrement plus large que la couche métallique pour augmenter le recouvrement source-grille et drain-grille. Une couche d'un matériau isolant 2 recouvre la face 10, chaque grille GR et les électrodes de lignes LG.

Une couche d'un matériau semiconducteur amorphe, du silicium amorphe par exemple, réalisée sous forme d'une mésa ME recouvre la grille GR et dépasse de part et d'autre de la grille. Cette couche est très mince pour minimiser les problèmes de photoconductivité.

Sur la mésa ME, un plot de matériau isolant D relativement épais recouvre une zone D correspondant à la projection de la grille GR sur la mésa ME. Eventuellement, ce plot D peut se prolonger de façon à recouvrir les électrodes de lignes LG sans que cela sorte de l'invention. La mésa ME peut être réalisée à l'aide d'un isolant épais de passivation tel que du $Si_3N_4$ recouvert d'une couche mince d'un oxyde tel que $SiO_2$.

De part et d'autre de la mésa ME, une couche 5 d'un matériau semiconducteur dopé, du silicium forment dopé par exemple, recouverte d'une couche de métal 6 s'étend vers l'emplacement d'une électrode de colonne CL et vers l'emplacement d'un élément image PX. Ces couches 5 et 6 recouvrent aussi la partie supérieure de la mésa ME.

Une électrode de colonne en métal CL orthogonale à l'électrode de ligne LG est connectée à une partie de la couche de métal 6 qui constitue alors par exemple le drain DR du transistor.

Un élément image en oxyde d'indium ITO est connecté à une autre partie de la couche de métal 6 qui constitue alors la source du transistor.

On a ainsi décrit un exemple de réalisation d'un transistor de commande intégré sur une face de substrat pour écran de visualisation électrooptique dans lequel, la couche de silicium amorphe 2 est protégée de la lumière par le plot isolant D et dans lequel les capacités parasites sont rendues minimales et constantes sur tout l'écran grâce à l'alignement des sources et drains par rapport aux grilles à l'aide des plots isolants.

Pour compléter cet écran et en faire un écran à cristal liquide il convient de prévoir, comme cela est décrit en relation avec la figure 1, une deuxième plaque 1' munie d'au moins une électrode et enserrant un cristal liquide CX.

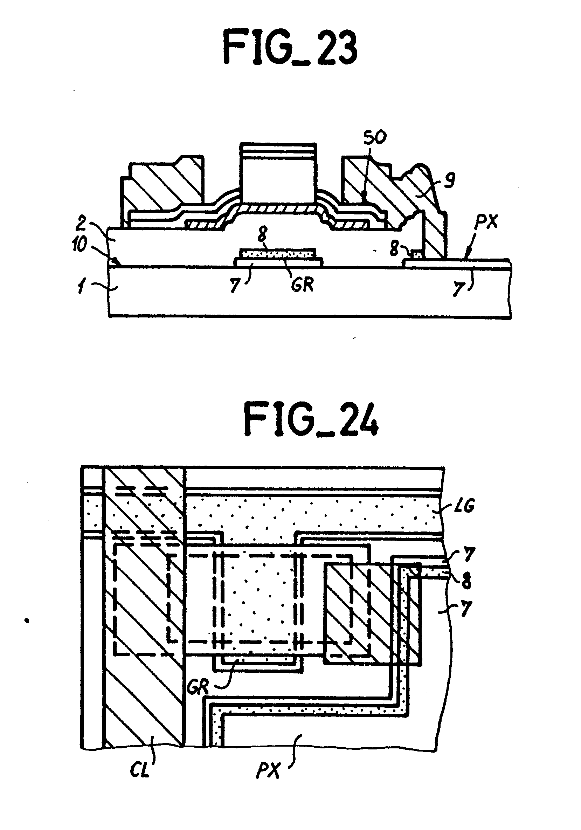

Selon une variante de réalisation représentée sur les figures 23 et 24, chaque élément image PX est réalisé directement sur la face 10 du substrat au lieu d'être réalisé la couche d'isolant 2 comme dans la réalisation précédente. Dans ce cas, l'isolant 2 est gravé pour dégager chaque élément image PX. La source SO de chaque transistor est alors connectée à la partie supérieure d'un élément image PX. Selon l'exemple de réalisation des figures 23 et 24, un élément métallique 9 effectue cette connexion.

De plus, la grille GR et l'élément image PX sont réalisés tous deux par une couche d'oxyde d'indium 7 et par une couche métallique. La couche métallique 8 est enlevée sur la quasi totalité de la surface de l'élément image PX et la partie restante permet une connexion plus efficace avec l'élément métallique 9.

Les autres éléments du transistor de commande sont constitués de la même façon que ceux décrits précédemment en se reportant aux figures 13 et 14.

On va maintenant décrire un exemple du procédé de réalisation de l'invention.

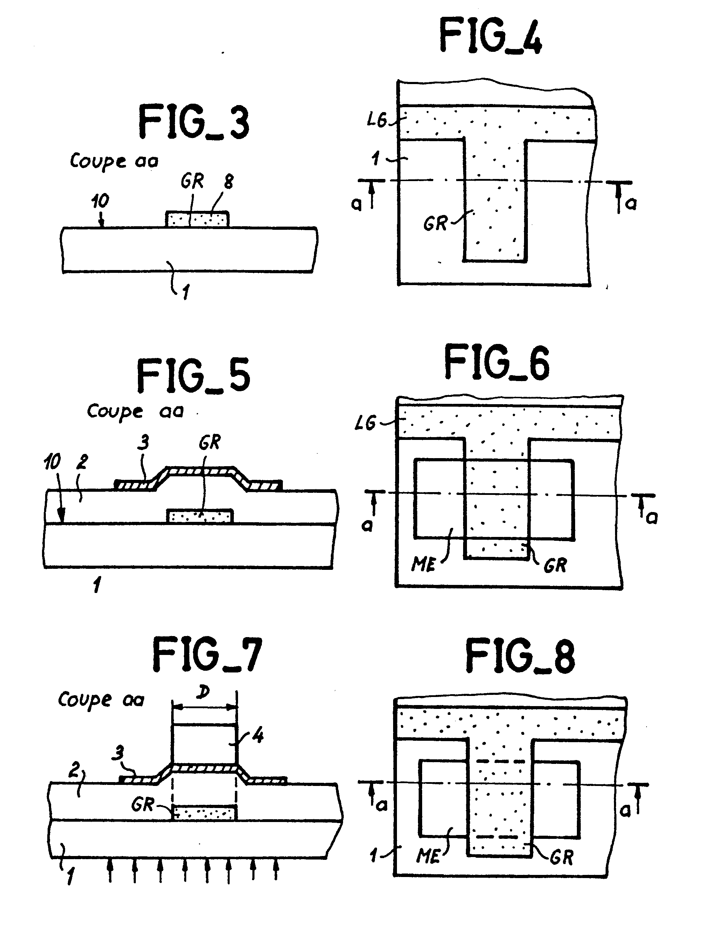

Différentes étapes de ce procédé sont illustrées par les figures 3 à 14.

Au cours d'une première étape, on réalise, sur une face 10 d'un substrat 1, une couche 8 d'un matériau métallique.

Au cours d'une deuxième étape, on grave dans la couche métallique 8, des électrodes de lignes LG possédant des dents GR situées chacune à un point de croisement de la matrice à commander telle qu'elle a été décrite en se raportant à la figure 1. Ces dents serviront de grilles dans les transistors qui vont être fabriqués dans les étapes qui vont suivre. On obtient ainsi une structure telle que représentée en figures 3 et 4.

Au cours d'une troisième étape, on réalise une couche d'un matériau isolant 2 recouvrant la face 10, les électrodes de lignes LG et les grilles GR. Cet isolant peut être du $SiO_2$ ou du $Si_3N_4$ par exemple.

Au cours d'une quatrième étape on réalise le dépôt d'une couche 3 d'un matériau semiconducteur amorphe, tel que du silicium amorphe. Cette couche est très mince pour minimiser les problèmes de photoconductivité.

Au cours d'une cinquième étape, cette couche 3 est gravée de façon à ne laisser subsister au-dessus de chaque grille GR qu'une partie en forme de mésa ME qui déborde de chaque côté de la grille. On obtient ainsi une structure représentée par les figures 5 et 6.

Au cours d'une sixième étape on réalise une couche 4 épaisse d'un matériau isolant tel que du $Si_3N_4$ que l'on recouvre éventuellement d'une couche mince de $SiO_2$.

Au cours d'une septième étape, on procède à l'élimination du matériau isolant de telle façon à garder le matériau isolant au moins au-dessus de chaque grille GR et éventuellement au-dessus des électrodes de lignes LG. Pour cela, on recouvre la surface de l'isolant d'une couche de résine positive. On insole l'ensemble à travers le substrat 1 à l'aide d'une source d'éclairement comme cela est représenté par les flèches indiquées sur la figure 7. Les grilles GR et les électrodes de lignes LG servent de masque de lumière pour la couche 4 d'isolant située au-dessus et après développement, l'isolant non masqué est éliminé. On obtient ainsi une structure telle que représentée en figure 7. Comme on le voit sur la figure 7, au-dessus de la grille est conservé un plot isolant D de largeur correspondant à celle de la grille GR.

Au cours d'une huitième étape, on réalise une couche 5 fortement dopée d'un matériau semiconducteur, tel que du silicium, fortement dopé.

Il est à noter que cette couche de silicium ainsi que celle de silicium amorphe réalisée au cours de la quatrième étape peuvent être réalisées par décharge luminescente ou pulvérisation réactive.

Au cours d'une neuvième étape, on réalise une couche 6 d'un matériau métallique tel que du chrome ou du mobybdène par exemple.

Au cours d'une dixième étape, on grave la couche 5 de silicium et la couche 6 métallique pour réaliser la source SO et le drain DR de chaque transistor. Chacun de ces éléments, comme représenté en figures 9 et 10 relient le plot D à des zones situées de part et d'autre de la grille. On voit donc que le plot D permet de réaliser pour chaque transistor, et cela de façon sûre, des source et drain dont leurs extrémités sont dans l'alignement des bords de la grille. De cette façon, le transistor réalisé aura des capacités parasites réduites de façon maximum.

Au cours d'une onzième étape, on effectue le dépôt d'une autre couche métallique, tel que de l'aluminium, puis au cours d'une douzième étape on grave cette couche de façon à réaliser des électrodes de colonne CL en contact avec chaque drain DR comme cela est représenté en figures 11 et 12.

Au cours d'une treizième étape on effectue le dépôt d'une couche 7 d'un matériau conducteur tel que de l'oxyde d'indium-étain et dans cette couche on grave des éléments images, tels que PX, en contact avec une source SO.

On obtient ainsi un composant représenté par les figures 2, 13 et 14.

Au cours d'une quatorzième étape, on termine la réalisation de l'écran à cristal liquide selon des techniques connues en prévoyant des opérations de
- dépôt de couche d'ancrage ;
- mise en place de cales d'épaisseur ;
- réalisation d'une contre lame avec contre électrode transparente recouverte d'une couche d'ancrage ;
- mise en place du cristal liquide.

L'écran à cristal liquide selon l'invention est ainsi réalisé.

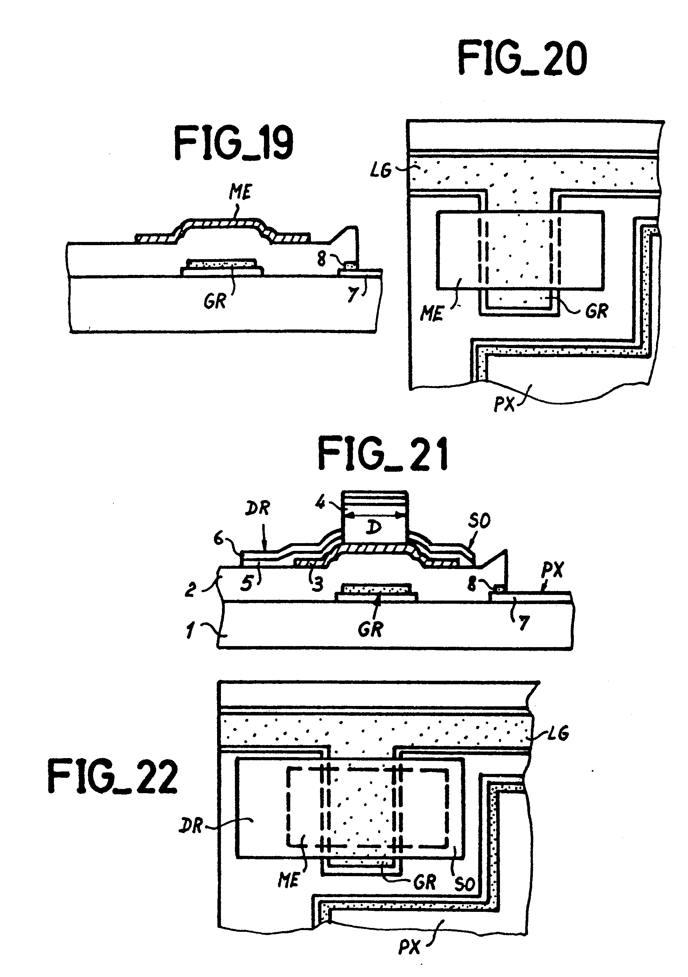

En se reportant aux figures 15 à 22 on va maintenant décrire une variante du procédé de l'invention.

Cette variante de procédé permet d'augmenter légèrement le recouvrement entre la grille métallique et les contacts source et drain pour éviter des résistances de contacts dans les transistors à couches minces. L'idée est de graver une double couche faite d'un conducteur transparent et d'un métal et de surgraver le métal pour obtenir une grille de transistor à couche mince transparente sur les bords. Ceci peut se faire avec un même nombre de niveaux de masquage et qui apporte en plus une redondance sur les lignes et les colonnes en les doublant, et des contacts extérieurs de même nature en bout de lignes et de colonnes.

Selon une variante du procédé de réalisation de l'invention représentée par les figures 15 à 22 on prévoit avant la première étape du procédé précédemment décrit un dépôt sur la face 10 du substrat d'une couche mince 7 d'un matériau conducteur tel que de l'oxyde d'indium partiellement oxydé. On effectue ensuite le recuit à haute température de cette couche.

La première étape est ensuite réalisée par évaporation ou pulvérisation cathodique d'une couche métallique 8.

Au cours de la deuxième étape, la couche métallique 8 et la couche conductrice 7 sont gravées pour réaliser les grilles GR et les lignes LG, ainsi que les éléments images PX tel que cela est représenté par les figures 15 et 16.

La couche métallique 8 peut être surgravée de façon à être plus étroite que la couche 7 de façon à augmenter le recouvrement source-grille et drain-grille du transistor.

Les troisième, quatrième et cinquième étapes se déroulent comme décrites dans le procédé précédent. On obtient ainsi la structure représentée en figures 17 et 18. Par contre, entre la cinquième et la sixième étapes précédentes, on prévoit une opération de gravure de la couche d'isolant 2 et de la couche de métal 8 de façon à faire apparaître la couche 7 d'oxyde d'indium-étain à l'emplacement des éléments images PX.

La sixième étape et les suivantes jusqu'à la douzième étape sont réalisées comme décrit précédemment.

Au cours de la douzième étape, on grave en plus des électrodes de colonnes CL, des éléments de connexion 9 connectant chaque source SO à l'élément image PX que doit commander le transistor auquel appartient cette source. On obtient ainsi le composant représenté sur les figures 23 et 24 où l'on voit l'élément de connexion 9 connecté à la couche d'oxyde d'indium-étain 7 de l'élément image PX et au reste de la couche métallique 8.

Les treizième et quatorzième étapes qui consistaient à réaliser les éléments images ont déjà été réalisés dans la variante du procédé ainsi décrite et n'ont pas lieu d'être exécutés.

On passe donc à la quinzième étape l'écran de visualisation de l'invention est complété comme décrit précédemment.

Selon une autre variante du procédé de l'invention, on prévoit de remplacer tout ou partie de la couche de matériau isolant 4 par une couche organique et de la dissoudre après insolation en utilisant les grilles comme masque de lumière ce qui permet de réaliser également un autoalignement des contacts sources et drains par rapport aux grilles.

Selon une autre variante du procédé de l'invention, la couche 3 de silicium amorphe est électriquement compensée ou même faiblement de type p afin d'en diminuer la photoconductivité et ainsi de limiter l'influence de la lumière sur les caractéristiques des transistors.

Selon une autre variante du procédé de l'invention chaque mésa ME de matériau semiconducteur peut s'étendre jusqu'au croisement entre une électrode de ligne et une électrode de colonne pour diminuer les problèmes de gravure sur les bords des lignes.

Il est bien évident que la description qui précède n'a été faite qu'à titre d'exemple et que d'autres variantes peuvent être envisagées sans sortir du cadre de l'invention.

**Revendications**

1. Ecran de visualisation électrooptique à transistors de commande comportant :
- une première et une deuxième lames parallèles (1, 1') enserrant un matériau électrooptique (CX) ;
- la première lame (1) étant munie sur sa face (10) en contact avec le matériau électrooptique (CX) d'une matrice d'éléments images (PX11 à PX22) arrangés en lignes et colonnes, d'électrodes de commande de lignes (LG1, LG2) à raison d'une électrode associée à chaque ligne d'éléments image de ladite matrice et disposée parallèlement à chaque ligne d'élements image, et de transistors de commande (T11 à T22) à raison d'un transistor par élément image (PX11 à PX22) couplant celui-ci à ladite électrode de commande de ligne ;
- la deuxième lame (1') étant munie sur sa face (10') en contact avec le matériau électrooptique (CL) d'au moins une électrode (F) ;
caractérisé en ce que chaque transistor comporte :
- une grille (GR) connectée à une électrode de commande de ligne (LG1, LG2) et recouverte d'une couche d'isolant (2) ainsi que d'une couche de matériau semiconducteur amorphe (3) ;
- un drain (DR) connecté à une électrode de commande de colonne (CL), reposant sur la couche de matériau semiconducteur amorphe (3) par l'intermédiaire d'une couche de semiconducteur dopé (5), ce drain (DR) ne recouvrant pas une zone (D) située au-dessus de la grille (GR) ;
- un élément métallique constituant la source (SO) du transistor, connecté à un élément image et reposant sur la couche de matériau semiconducteur amorphe (3) par l'intermédiaire d'une couche de semiconducteur dopé (5), cette source (SO) ne recouvrant pas la zone (D) située au-dessus de la grille (GR) ;
- un plot en matériau isolant (4) situé entre le drain (DR) et la source (SO), recouvrant la zone (D) située au-dessus de la grille et ne laissant pas passer la lumière.

2. Ecran de visualisation selon la revendication 1, caractérisé en ce que le plot en matériau isolant (4) est recouvert d'une couche métallique (6).

3. Ecran de visualisation selon la revendication 2, caractérisé en ce que le plot en matériau isolant est recouvert d'une couche de matériau semiconducteur (5) située entre le plot et la couche métallique (6).

4. Ecran de visualisation selon la revendication 1, caractérisé en ce que l'élément image (PX) est situé sur la couche d'isolant (2) et possède une partie de connexion avec la source (SO) située sur la source (SO).

5. Ecran de visualisation selon la revendication 1, caractérisé en ce que l'élément image (PX) est situé directement face (10) du substrat, la couche d'isolant (2) étant gravée à l'emplacement de l'élément image (PX) et la source (SO) étant située sur l'élément image (PX) dans sa partie de connexion à l'élément image (PX).

6. Ecran de visualisation selon la revendication 1, caractérisé en ce que la grille est une couche double d'oxyde d'indium et de métal, la couche d'oxyde d'indium étant plus large que la couche de métal pour augmenter le recouvrement source-grille et drain-grille du transistor.

7. Procédé de réalisation d'un écran de visualisation selon la revendication 1, caractérisé en ce qu'il comporte les étapes suivantes :

a) une première étape de dépôt sur une face (10) d'un substrat (1) d'une première couche de métal ;

b) une deuxième étape de découpe par gravure dans cette couche de métal, d'électrodes de lignes (LG) et de grilles (GR) connectées à ces électrodes de lignes ;

c) une troisième étape de dépôt d'une première couche d'un matériau isolant (2) ;

d) une quatrième étape de dépôt d'une couche d'un matériau semiconducteur amorphe (3) ;

e) une cinquième étape de découpe par gravure, dans la couche de matériau semiconducteur amorphe (3), de mésas (ME) ;

f) une sixième étape de dépôt, sur l'ensemble ainsi obtenu, d'une deuxième couche épaisse d'un matériau isolant (4) ;

g) une septième étape d'élimination de la deuxième couche de matériau isolant (4) de façon à obtenir des plots (D) en matériau isolant situés au-dessus des grilles (GR) ;

h) une huitième étape de dépôt d'une couche fortement dopée de matériau semiconducteur (5) ;

i) une neuvième étape de dépôt d'une deuxième couche de métal (6) ;

j) une deuxième étape de gravure, sur chaque mésa (ME), d'un drain (DR) atteignant un plot (D) situé sur la mésa ainsi qu'une source (SO) atteignant ledit plot et se prolongeant vers l'emplacement d'un élément image ;

k) une onzième étape de dépôt d'une troisième couche de métal ;

l) une douzième étape de gravure, dans la troisième couche de métal, d'électrodes de colonnes (CL) en contact avec des drains (DR) ;

m) une treizième étape de dépôt d'une couche conductrice ;

n) une quatorzième étape de gravure, dans ladite couche, d'éléments images (PX) en contact avec des sources (SO) ;

o) une quinzième étape de finition d'un écran comportant les opérations suivantes

:
- dépôt d'une couche d'ancrage ;
- mise en place de cales d'épaisseur ;
- réalisation d'une contre lame avec contre électrode transparente recouverte d'une couche d'ancrage ;
mise en place d'un cristal liquide.

8. Procédé selon la revendication 7, caractérisé en ce que :
- il comporte avant la première étape une phase de réalisation sur la face (10) du substrat (1), d'une couche d'oxyde d'indium-étain (7) ;
- au cours de la deuxième étape la découpe par gravure permet la réalisation d'éléments images (PX) ;
- entre la cinquième étape et la sixième étape on prévoit une étape de gravure au-dessus des éléments images (PX), de la première couche d'isolant (2) et de la première couche de métal (8) ;
- les étapes suivantes de la sixième à la douzième étapes étant exécutées, la douzième étape permettant, de plus, la gravure d'éléments de connexion (9) connectant chaque source (SO) à un élément image (PX) ;
- le procédé passe directement de l'exécution de la douzième étape à l'exécution de la quinzième étape ;

9. Procédé selon la revendication 7 ou 8, caractérisé en ce que les couches de matériau semiconducteur sont réalisées par décharge luminescente ou pulvérisation réactive.

10. Procédé selon l'une des revendications 7 ou 8, caractérisé en ce que la septième étape se fait par dépôt d'une couche d'une résine négative sur la deuxième couche de matériau isolant (4) et insolation à travers le substrat (1), la première couche de matériau isolant (2) de la couche de matériau semiconducteur amorphe (3), les grilles (GR) servant de masque.

11. Procédé selon l'une des revendications 7 ou 8, caractérisé en ce que le matériau isolant de la deuxième couche d'isolant (4) est un polyimide photosensible et que son élimination au-dessus des grilles (GR) se fait par insolation à travers le substrat (1), les grilles (GR) servant de masques, puis par développement et enlèvement des parties insolées et enfin par recuit du polyimide restant.

12. Procédé selon la revendication 7, caractérisé en ce que la deuxième couche de matériau isolant (4) est une couche de matériau organique.

13. Procédé selon la revendication 7, caractérisé en ce que lors de la quatrième étape la couche de matériau semiconducteur amorphe (3) est électriquement compensée ou faiblement dopée.

FIG_1

0267825

0267825

# FIG_2

FIG_3
Coupe aa

FIG_4

FIG_5
Coupe aa

FIG_6

FIG_7
Coupe aa

FIG_8

0267825

# FIG_9

DR  6  6  4  D  5  SO
5  3  2  GR  1

# FIG_10

DR  6  SO  1

# FIG_11

CL  6  5  D  SO
6  5  2  GR  1

# FIG_12

DR  SO

# FIG_13

CL  6  4  D  5  SO  7
6  2  10  DR  ME  3  GR  1

# FIG_14

LG

0267825

# FIG_16

# FIG_15

Coupe aa

# FIG_17

Coupe aa

# FIG_18

0267825

**FIG_20**

**FIG_19**

**FIG_21**

**FIG_22**

0267825

# FIG_23

# FIG_24

Office européen
des brevets

RAPPORT DE RECHERCHE EUROPEENNE

Numero de la demande

EP 87 40 2276

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | EP-A-0 196 915  (MATSUSHITA ELECTRIC INDUSTRIAL CO.LTD) <br> * Page 1, lignes 1-7; page 3, ligne 20 - page 6, ligne 25; page 7, lignes 5-10; page 7, ligne 17 - page 8, ligne 2 * <br> --- | 1-5,7,9 -13 | G 02 F  1/133 <br> H 01 L  29/78 |
| A | 1983 SID INTERNATIONAL SYMPOSIUM DIGEST OF TECHNICAL PAPERS, SOCIETY FOR SID INFORMATION DISPLAY, 1ère édition, mai 1983, pages 144-145, Lewis Winner, Coral Gables, US; K. ASAMA et al.: "A self-alignment processed a-Si TFT matrix circuit of LCD panels" <br> * Figure 1 * <br> --- | 1 | |
| A | CONFERENCE RECORD OF THE 1985 INTERNATIONAL DISPLAY RESEARCH CONFERENCE, San Diego, California, 15-17 octobre 1985, pages 30,31, IEEE, New York, US; T. SAKAI et al.: "A color LC panel using a very thin film transistor (V-TFT)" <br> * Figures 1,3 * <br> ----- | 1 | DOMAINES TECHNIQUES RECHERCHES (Int. Cl.4) <br><br> G 02 F |

Le présent rapport a été établi pour toutes les revendications

| Lieu de la recherche | Date d'achèvement de la recherche | Examinateur |
|---|---|---|
| LA HAYE | 26-01-1988 | GALANTI M. |

EPO FORM 1503 03.82 (P0402)